# EUROPEAN PATENT SPECIFICATION

(11) **EP 1 959 263 B1**
(45) Date of publication and mention of the grant of the patent: **09.12.2020**
(21) Application number: 07002989.7
(22) Date of filing: 13.02.2007
(51) Int. Cl.: H02J 13/00, G01R 19/145

(54) **Power sensing in electrical systems**
Stromabtastung in elektrischen Systemen
Détection électrique dans des systèmes électriques

(43) Date of publication of application: 20.08.2008
(73) Proprietor: Vestel Elektronik Sanayi ve Ticaret A.S., 45030 Manisa (TR)
(72) Inventor: Sariarslan, M. Kursat, Organize Sanayi Bölgesi 45030 Manisa (TR)
(74) Representative: Cayli, Hülya

(56) References cited:
- WO-A1-2006/062733
- GB-A- 1 178 653
- GB-A- 2 342 455
- JP-A- 2000 221 218
- JP-A- 2006 105 955
- US-A- 4 476 709
- US-A- 5 488 304
- US-A- 5 661 396

## Description

### Power sensing in electrical systems

The present invention relates to electrical systems, for example domestic A/V systems, and more particularly to a method and system for power sensing in such systems.

The invention has applications in numerous situations in which an electrical system has multiple parts (i.e. circuitry units, modules or cards), such as audio amps and driver circuits.

There are several methods currently used, in A/V systems such as TV receivers, for detecting the mains AC power existence, and using this data for other purposes, and some of these will be discussed below.

### 1. DC Supply Feedback

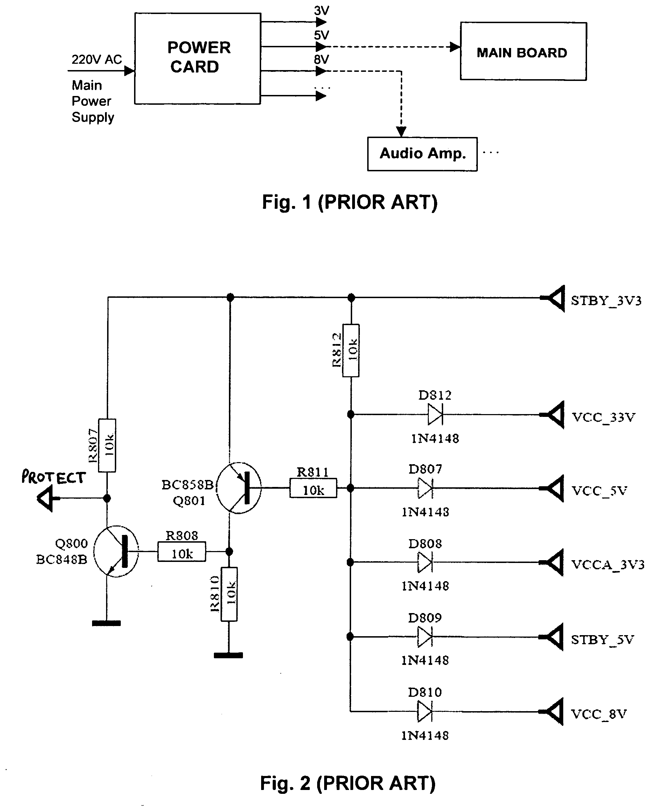

Reference is made to Fig. 1 (PRIOR ART), which shows the power distribution layout in a TV Receiver. Generally, TV receivers use a switch mode power supply to regulate and supply power to run the internal integrated circuits in the receiver, including the microcontroller, audio processor, video processor, etc. The main AC power enters the power card in the receiver and DC voltages at various levels are generated at the secondary side to power/run the internal circuits.

Similarly JP 2006105955 discloses a device having a power sensing unit capable to detect power in a power cable of an electrical equipment.

In some receivers, the DC voltages generated at the secondary side of the power card are used to check the existence of main power to the system. An exemplary circuit for this type of technique can be seen in Figure 2. In this circuit, stand-by 3.3V is used as reference voltage. It is used because this voltage's falling (decay) time is generally shorter than the others. If all the signals exist, then transistor Q801 gets fed by the supply and doesn't switch on, as its base is also connected to 3.3V. Then, the output (PROTECT) of the circuit becomes "high". This high level is detected by the microcontroller (not shown) and the system starts or continues to operate. If any short circuit appears on any of the DC voltage lines on the right hand side of the circuit, then current on the stand-by (3.3V) line flows to that low level point through the respective diode (807-812). At that time, the base of transistor Q801 becomes low and transistor Q800 switches on, and output (PROTECT) becomes "low" for a moment. This low level is detected by the microcontroller and drives the system into stand-by mode.

However, the technique shown in Figure 2 does not provide any exact information about the primary side of the power supply (left hand side of power card in Fig. 1). It is more useful in detecting the problems (short circuit, etc.) in DC voltage levels (left hand side), and this kind of detection is not fast enough to protect the system. Problems associated with such systems include the following.
(a) The technique cannot determine definitely whether the reason for the problem on one of the DC voltage lines is the short circuit of the line or the non-existence of the main AC power supply. If any DC voltage is short circuited, the system goes into protection mode while the main AC supply still exists. This causes an unstable situation.
(b) The circuit speed depends on all the connected voltage values. It means that in a power off instant, the circuit waits for the voltages to fall down to 2.6V (3.3V - 0.7V (diode barrier voltage)) to give an output for the microcontroller. The system will continue to operate until any of the connected lines drop to 2.6V. During this period, the system can easily crash due to the ICs which are switched off, because most of ICs stop operating if their supplies fall down to 80% of their normal levels. These non-operating ICs can load the communication lines (12C or digital lines) and disturb the data.
(c) If this circuit gives a low level to microcontroller, then the controller drives the system to stand-by mode. But the circuit cannot indicate anything about the AC power situation. At that moment, if the keyboard or the remote controller is used, then controller wants to power on the system. If main power is not connected, the microcontroller cannot power on the system and it goes into the stand-by mode again. This loop continues until all stand-by voltages drop down to 2.6V. During this process there still exists a possibility for the system to crash due to unstable (falling) voltages.
(d) For the "pop noise" problem, the system always needs a very fast voltage signal (voltage whose falling time is faster) to control an audio mute circuit or mute the port of an audio amplifier. However, the circuit of Fig. 2 is not fast enough to control the mute circuit to cancel the "pop noise" by using the microcontroller. To get satisfactory performance, the fastest falling voltage is always needed. Reliable results cannot be obtained if the DC voltages in secondary (right hand) part of the power card are used, because the rising and falling times of these DC voltages change according to the specifications of each system.

### 2. AC Feedback

There exist circuits available on some power cards that enable the acquisition of feedback from the primary side of the power card. The existence of the AC supply can be detected by getting direct feedback from the primary side. However, not all power cards have this circuit. Also, this technique causes some safety and instability problems, because of working at the high voltage side.

A problem that arises generally in TV systems, during the power on & off stage, is that DC supplies are not fast enough, due to the capacitors on the power card and on the chassis. When the system is powered off from the power switch, it takes some time for DC voltages to drop down. This delay is sometimes too long according to power supply and system design.

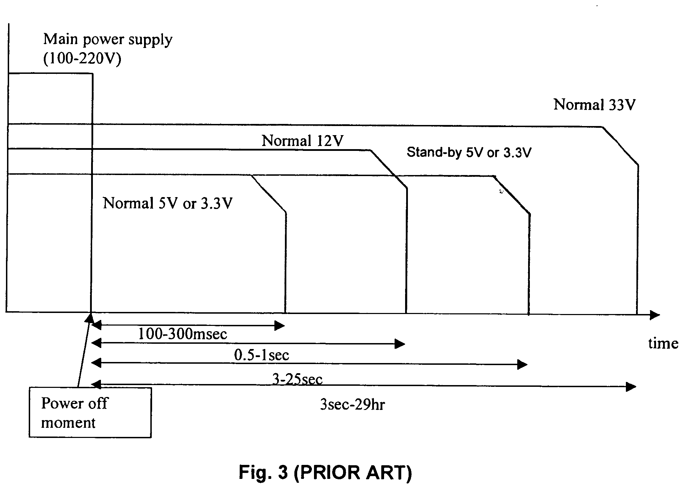

In Figure 3 (PRIOR ART) are illustrated the falling times of the dc power supplies in a traditional SMPS (switch mode power supply) board. Due to the capacitors on the filters, DC voltages fall down slower than the main power supply (100V-220V). But these voltages also each have their own different falling times, because of the different load and the capacitor values of the DC line. For example, stand-by voltages are generally used to supply only the microcontroller and some small circuits as, in stand-by mode, power consumption must be very low. Thus, the load on the stand-by voltage line will be high. Consequently, discharging time of the capacitors for this DC voltage increases. But other voltages (normal voltage) supply lots of circuits and ICs at the same time. These ICs and circuits load the voltage line. However, as a load, they are parallel to each other, so load on normal voltages will be low. Capacitors discharge more quickly and falling time shortens.

The delay of the falling times of the DC voltages causes some problems. One of these is the pop noise problem in audio power stage. In classical systems, the mute circuits of the audio power amplifiers are controlled by internal DC voltages. But the response times of these voltages vary from system to system, as explained above. Thus, when the system is shut down, an undesired noise is produced by the audio source or by the audio amplifier itself. In order to avoid hearing this noise, it would be desirable for the audio source or the audio amplifier to be muted (according to an AC power existence data) before their DC supplies fall down.

A second problem arises at the moment of shut down of A/V systems. In the present disclosure, "A/V system" includes, among many other devices that will be familiar to persons skilled in the art, TV sets, computers, DVD players, set top boxes etc. As explained above, the DC voltages in such systems have different falling and rising times. These times are affected by the load and the capacitance on that line. The differences between these falling and rising times cause some problems when the system is turned on or off. For example, when the main power of the system is turned off, generally normal voltages fall-down faster than the stand-by voltage. As the microcontroller supplies are connected to the stand-by voltage, the microcontroller continues to operate and tries to communicate with other circuits. As these circuits have no power, they load the communication lines and cause the system to crash, or to work in an unstable condition. The software cannot get correct information and the memory becomes damaged or erased. Thus, there is a need to inform the microcontroller when the main AC power supply is off.

A third problem arises when A/V system is turned off and on very quickly. When such systems are powered on, the circuits in the system wait for a reset signal, which is generally generated by the microcontroller, before starting their operations. When the system is switched off, some circuits lose their power before the microcontroller, as the microcontroller is connected to the stand-by voltage and the falling-down period of the stand-by voltage is longer than most of the other circuits. Before the stand-by voltage falls down, if the system is quickly switched back on, the other circuits will need a reset signal to re-operate. As the microcontroller cannot detect the power off situation, it does not send the reset signals for the other circuits and continues its normal operation. Again, the system does not operate properly in this situation, and there is a need the microcontroller to be informed about the main power (off) situation, in order for it to reset the other circuits.

This invention seeks to overcome the aforementioned problems and provide an improved method and system for power sensing in electrical (especially A/V) systems The present invention provides a mains-powered domestic electrical system with a power sensing unit, comprising: an antenna, adapted to be mounted on or near a mains cable of the electrical system, for providing, in use, an induced signal when the mains cable is conveying electrical power; and an analog signal processing circuit, coupled to the antenna, for receiving the induced signal and outputting a power sense signal, indicative of whether or not the mains cable is conveying electrical power.

Preferably, the analog signal processing circuit includes a first stage, for amplifying and inverting the induced signal, and outputting a first output signal. Preferably, the analog signal processing circuit further includes a second stage, coupled to the first stage, for receiving the first output signal, eliminating the DC level therefrom, and outputting a second output signal. Preferably, the analog signal processing circuit further includes a third stage, coupled to the second stage, for receiving the second output signal, converting the AC signal to DC, and outputting a third output signal; wherein the power sense signal comprises a signal indicating that the mains cable is conveying electrical power if the third output signal having a LOW DC level, and conversely. Preferably, the analog signal processing circuit further includes a fourth stage, coupled to the third stage, for receiving the third output signal, inverting the signal, and outputting a fourth output signal; wherein the power sense signal comprises a signal indicating that the mains cable is conveying electrical power if the fourth output signal having a HIGH DC level, and conversely.

Above mentioed mains-powered domestic electrical system, further comprises: processing circuitry; a plurality of circuitry units; UI circuitry; wherein the processing circuitry is coupled to the power sensing unit and to the plurality of circuitry units, and wherein the processing circuitry is programmed for receiving a first user input signal (POWER OFF) from the UI circuitry; and transmitting a first control signal to one or more of said plurality of circuitry units if the power sense signal indicates that the mains cable is not conveying electrical power, thereby disabling the or each of said circuitry units.

According to another aspect of the invention there is provided an electrical system, comprising: a power sensing unit, associated with mains supply of the electrical system, for providing, in use, a power sense signal, indicative of whether or not the mains cable is conveying electrical power; processing circuitry; a plurality of circuitry units; UI circuitry; wherein the processing circuitry is coupled to the power sensing unit and to the plurality of circuitry units, and wherein the processing circuitry is programmed for receiving a first user input signal (POWER OFF) from the UI circuitry; and transmitting a first control signal to one or more of said plurality of circuitry units if the power sense signal indicates that the mains cable is not conveying electrical power, thereby disabling the or each of said circuitry units.

In one embodiment, said circuitry units include: an intermediate control unit, coupled to the processing circuitry, and an audio amplifier, coupled to the intermediate unit.

In one embodiment, the intermediate control unit is operable, in response to the first control signal from the processing circuitry, for transmitting a second control signal to the audio amplifier thereby disabling the audio amplifier.

In another embodiment, the intermediate control unit is coupled to the power sensing unit; wherein the processing circuitry is operable to transmit a third control signal in response to receiving the first user input signal (POWER OFF); and wherein the intermediate control unit is operable, in response to the third control signal from the processing circuitry, for transmitting a second control signal to the audio amplifier, thereby disabling the audio amplifier if the power sense signal indicates that the mains cable is not conveying electrical power.

Alternatively of additionally, the processing circuitry is programmed for receiving a second user input signal (POWER ON) from the UI circuitry; and transmitting a fourth control signal to one or more of said plurality of circuitry units if the power sense signal indicates that the mains cable is conveying electrical power, thereby enabling the or each of said circuitry units.

According to another aspect of the invention there is provided an A/V system, comprising: the system of any of claims 2 to 3 of the appended claims, wherein the audio amplifier comprises an audio amplification circuit; and wherein the intermediate control unit comprises an audio amp mute circuit. The system may be embodied in a TV system, computer, VCR, DVD player, or set-top box.

According to another aspect of the invention there is provided a method carried out in an electrical system, the electrical system comprising the power sensing unit, processing circuitry, a plurality of circuitry units and UI circuitry; wherein the processing circuitry is coupled to the power sensing unit and to the plurality of circuitry units; the method comprising: receiving a first user input signal (POWER OFF) from the UI circuitry; and transmitting a first control signal to one or more of said plurality of circuitry units if the power sense signal indicates that the mains cable is not conveying electrical power, thereby disabling the or each of said circuitry units.

According to another aspect of the invention there is provided a method carried out in an electrical system, the electrical system comprising: a power sensing unit, associated with mains supply of the electrical system, for providing, in use, a power sense signal, indicative of whether or not the mains cable is conveying electrical power; processing circuitry; a plurality of circuitry units; and UI circuitry; wherein the processing circuitry is coupled to the power sensing unit and to the plurality of circuitry units; the method comprising: receiving a first user input signal (POWER OFF) from the UI circuitry; and transmitting a first control signal to one or more of said plurality of circuitry units if the power sense signal indicates that the mains cable is not conveying electrical power, thereby disabling the or each of said circuitry units.

Preferably, said circuitry units include: an intermediate control unit, coupled to the processing circuitry, and an audio amplifier coupled to the intermediate unit. In one embodiment, the method comprises operating the intermediate control unit, in response to the first control signal from the processing circuitry, to transmit a second control signal to the audio amplifier, thereby disabling the audio amplifier. In one embodiment, the intermediate control unit is coupled to the power sensing unit; wherein the method includes: using the processing circuitry, transmitting a third control signal in response to receiving the first user input signal (POWER OFF); and using the intermediate control unit, in response to the third control signal from the processing circuitry, transmitting a second control signal to the audio amplifier, thereby disabling the audio amplifier, if the third output signal of the power sensing unit is LOW or the fourth output signal of the power sensing unit is HIGH.

Alternatively of additionally, the method comprises: receiving a second user input signal (POWER ON) from the UI circuitry; and transmitting a fourth control signal to one or more of said plurality of circuitry units if the power sense signal indicates that the mains cable is conveying electrical power, thereby enabling the or each of said circuitry units.

The method may be carried out in an A/V system, wherein the audio amplifier comprises an audio amplification circuit; and wherein the intermediate control unit comprises an audio amp mute circuit.

According to another aspect of the invention there is provided a programmable electrical system when suitably programmed for carrying out at least the steps of any of claims 6 to 8 of the appended claims.

According to another aspect of the invention there is provided a recordable, rewritable or storable medium having recorded or stored thereon data defining or transformable into instructions for execution by processing circuitry and corresponding to at least the steps of any of claims 6 to 8 of the appended claims.

According to another aspect of the invention there is provided a server computer incorporating a communications device and a memory device and being adapted for transmission on demand or otherwise of data defining or transformable into instructions for execution by processing circuitry and corresponding to at least the steps of any of claims 6 to 8 of the appended claims.

An advantage of the present invention over known techniques is that the power sensing circuit indicates direct information about whether the mains AC power supply is present (supplying current) or not, i.e. the status on the prim ary side of the power card.

Another advantage is that the invention is fast enough to provide a warning signal to a microprocessor, microcontroller, or other circuits when mains power is not present, in sufficient time for appropriate control operations to be made.

Embodiments of the invention will now be described in detail, by way of example, with reference to the accompanying drawings, in which:
Figure 1 (PRIOR ART) shows the power distribution layout in a known TV receiver;
Figure 2 (PRIOR ART) illustrates a known power control circuit (power card), showing DC voltages generated at the secondary side of the power card;
Figure 3 (PRIOR ART) shows the general power-off timings for a known switched-mode power supply (SMPS) board; and
Figure 4 illustrates an embodiment of a main power sense circuit employed according to one aspect of the invention;
Figure 5 illustrates schematically an embodiment of a system for noise cancellation in a TV receiver, according to a second aspect of the invention;
Figure 6 illustrates schematically another embodiment of a system for noise cancellation in a TV receiver, according to the invention;
Figure 7 illustrates schematically an embodiment of a system for secure mode operation in a TV receiver, according to one aspect of the invention;
Figure 8 is a flow chart showing the power-off sequence in a TV receiver, employed in the embodiments of Figs 5-7 ; and
Figure 9 is a flow chart showing the power-on sequence in a TV receiver, employed in the embodiments of Figs 5-7.

In the description and drawings, like numerals are used to designate like elements. Unless indicated otherwise, any individual design features and components may be used in combination with any other design features and components disclosed herein. The circuits and systems according to the invention are constructed/connected as described above in relation to Figs 1 to 3, except as described hereinafter.

Although the following description, for illustration purposes, relates to power sensing in A/V systems, and controlling circuitry units, modules or cards in response thereto, the invention is applicable in any situation where an electrical system is supplied by mains power, and there is a need to control the supply of power to parts of the system, or otherwise enable/disable them, on an individual basis or in relation to less than all parts, or in a sequenced or predetermined manner.

The present invention may be used, for example, to eliminate the audio noise and switch-on/off problems in a TV receiver by detecting the existence of main AC power. It can be used in any system that uses a power cable, as the method detects the existence of the power by sensing the magnetic field on the cable that is carrying alternating voltage (220V-110V etc.).

A principal technique employed by the invention is to detect the (non-)existence of the mains AC power supply to the system and inform the system, to protect the system from crashing or working in unstable conditions.

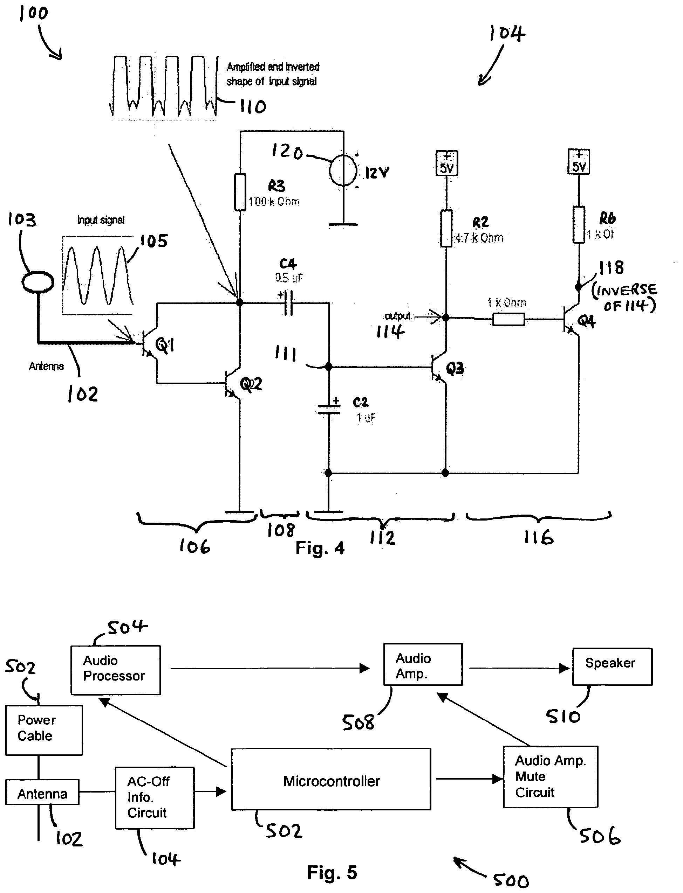

Figure 4 illustrates a mains power sense circuit or unit 100 employed according to one embodiment of the invention. The power sense unit 100 comprises an antenna 102 and signal processing circuitry 104. In the power sense unit 100 the antenna 102 detects the AC supply on the power cable and outputs a corresponding (induced) sinusoidal signal 105. A first stage 106 of the processing circuitry 104 performs amplification of the induced voltage. A second stage 108 of the processing circuitry 104 eliminates the DC level of the amplified signal 110. A third stage 112 of the processing circuitry 104 convertes the alternating signal to a DC level and producing an output at 114. A fourth stage 116 of the processing circuitry 104 inverts the output to produce a final output at 118. The stages of the processing circuitry 104 will be discussed in more detail later.

The antenna 102 may be a cable (coil) or metal plate. Generally, the antenna 102 comprises a conducting material, to sense electromagnetic flux created by the main power cable (not shown) that passes through the loop 103 of the coil antenna 102 of Fig. 4. While placed close to the mains power cable, the electromagnetic field around the power cable causes an alternating voltage (sinusoidal signal 105) to be induced in antenna 102. The voltage is alternating because main power lines have frequency between 50Hz and 60Hz (sinusoidal).

This AC voltage is then amplified (at stage 106 of the processing circuitry 104) with the Darlington type connected transistors (Q1 & Q2). The amplified output is at the point where R3, Q1 collector and the (+) pin of C4 are connected. This output is the inverse of input signal 104. A 12V supply 120 is used at this point, because a large swing in DC signal is needed.

In the second stage 108 of the processing circuitry 104, to eliminate the DC level in amplified signal 110, C4 is used. After C4 (i.e., at 111) the AC component only of amplified input signal is present, but the shape of this signal is not the same as the input signal, except its frequency.

In the third stage 112 of the processing circuitry 104, C2 is used to convert this AC signal to a DC signal, which is output at 114. This DC level is adequate for biasing the Q3 transistor. Q3 operates and the voltage level at the collector of Q3 drops to ground level.

If needed, a fourth (inverter) stage 116 (comprising Q4, R6) may be included in the system for getting "logic high" output at 118 when input signal 105 exists. This circuit operates sufficiently fast; however, to increase the speed, 5V can be used at the output transistors supplies, as falling time to approximately 0V from 5V is faster than that for falling to 0V from 12V.

Figure 5 illustrates schematically an embodiment of a system for noise cancellation in a TV receiver, according to a second aspect of the invention. The system 500 makes use of the antenna 102 and processing circuitry 104 (also known as AC-OFF Info. circuit) of Fig. 4. Referring to Fig. 5, the TV receiver 500 includes a microcontroller 502, coupled to the processing circuitry 104, to an audio processor 504 and to an audio amp mute circuit 506. Each of the audio processor 504 and the audio amp mute circuit 506 are connected to an audio amplifier 508, which in turn drives the speaker(s) 510 of the TV receiver.

It will be appreciated by persons skilled in the art that the invention may be embodied in a TV receiver in the form of a digital set-top box, VCR, DVD recorder or the like, in which case the speaker and other components may not be present.

As used herein, the audio processor 504, audio amp mute circuit 506, audio amplifier 508, and the like, each comprise a "circuitry unit"; and these may be provided within the TV receiver system as discrete IC components, parts of a system circuit on the same PCB, or as separate cards or units removably connectable to a main PCB.

The circuit of Fig 5 results in Pop Noise Cancellation. Audio Noise is cancelled as follows: if a power-off command is received (e.g. from the user via a remote control; not shown), and AC-off information is used (i.e. a LOW signal from the final (fourth) processing circuitry 104, or a HIGH signal from the third output, indicating mains power is not present). If such a signal is received by the microcontroller 502, it recognizes that the system is going into stand-by mode and mutes the audio source 504 or the audio amplifier 508beforetheir DC supplies fall down. In the embodiment of Fig. 5, the microcontroller 502 sends a control signal to the audio amp mute circuit 506, which in term disables the audio amplifier 508. If no such "AC-off" signal is received from the processing circuitry 104, or the microcontroller 502 receives a signal therefrom indicating AC power is still present, it omits to send a control signal to mute the audio source 504 or the audio amplifier 508.

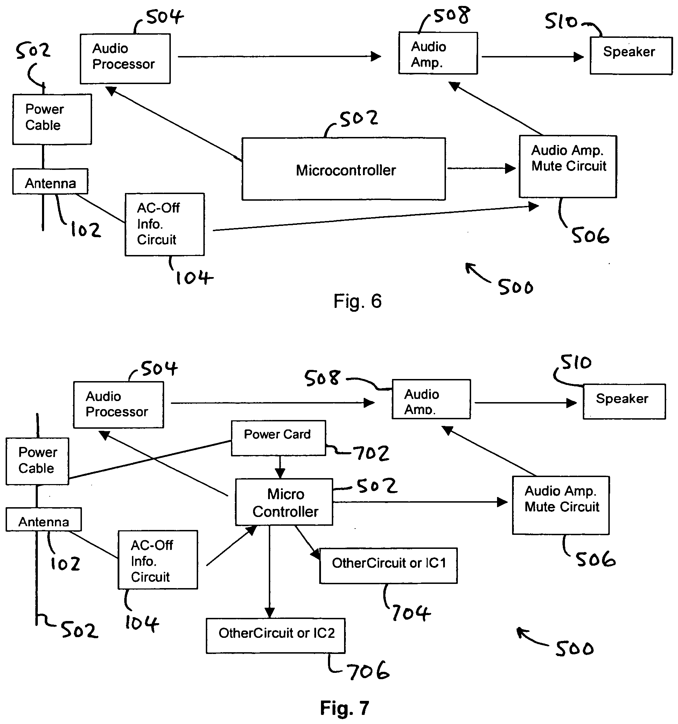

Figure 6 illustrates schematically another embodiment of a system for noise cancellation in a TV receiver, according to the invention. This is the same as the second embodiment, except as described hereinafter.

Figure 6 shows an alternative way of using the AC-off information (i.e. a LOW signal from the final (fourth) processing circuitry 104, or a HIGH signal from the third output, indicating mains power is not present) -- to control the audio amp mute circuit 506 directly. In this way, faster response may be enabled. Mute circuits can work well, but occasionally they don't, because of a different power supply or different power consumptions etc. These differences give rise to altered fall times and rise times of DC voltages. But the technique illustrated in Fig. 6 is system-independent: it is independent of the rest of the circuit, so it can produce always the fastest response.

Figure 7 illustrates schematically an embodiment of a system for secure mode operation in a TV receiver, according to one aspect of the invention. This is the same as the embodiment of Fig. 5, except as described hereinafter. The embodiment of Fig. 7 addresses the "second problem" and "third problem" explained hereinabove, that is by informing the microcontroller 502 about the change of status of the main AC power supply, by means of the processing circuitry 104 in Fig. 4. In this case, the AC-off signal received by the microcontrioller 502 can be used by it to transmit control signal to other circuitry units 704, 706, etc.

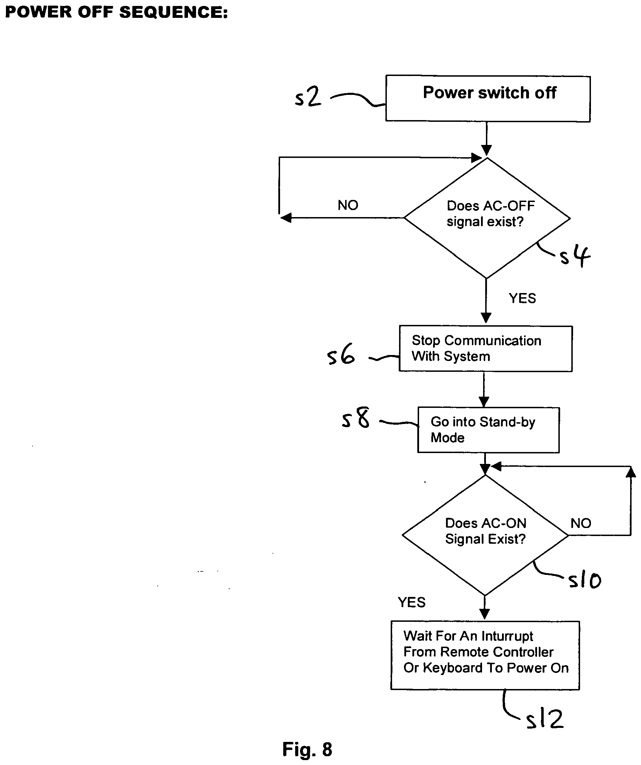

Figure 8 is a flow chart showing the power-off sequence in a TV receiver, employed in the embodiments of Figs 5. First, at s2, a power switch off signal is received from the user (e.g. via remote control; not shown). A check (s4) is then made to determine if an AC-OFF signal exists (i.e. a LOW signal from the final (fourth) processing circuitry 104, or a HIGH signal from the third output, indicating mains power is not present). If it is not, this check continuously repeats. If the AC-OFF signal is present, communication with the system is stopped (s6), and the system is switched into stand-by mode (s8).

Next, a check (s10) is made to determine whether an AC-ON signal exists (i.e. a HIGH signal from the final (fourth) processing circuitry 104, or a LOW signal from the third output, indicating mains power is still present). If it doesn't, the check (s10) continuously repeats. However, if the AC-ON signal is present, the system waits for an interrupt from the remote control or keyboard, to power on (s12). The steps s10 and s12 are used for the "quick power off-on" situation. This is used because the power-on command can occur before all the voltages within the system have fallen down. If a"power-on" command doesn't occur, then voltages will fall down and the system will shut down.

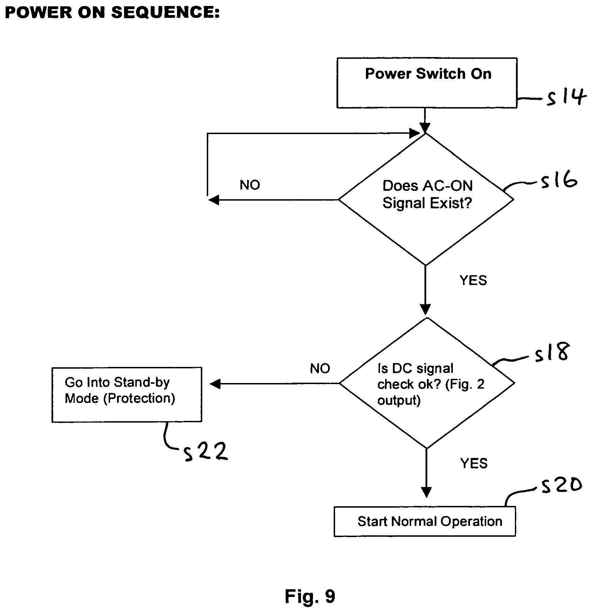

Figure 9 is a flow chart showing the power-on sequence in a TV receiver, employed in the embodiments of Figs 5. First, at s14, a power switch on signal/command is received from the user (e.g. via remote control; not shown). A check (s16) is then made to determine if an AC-ON signal exists (i.e. a HIGH signal from the final (fourth) processing circuitry 104, or a LOW signal from the third output, indicating mains power is still present). If it is not, this check continuously repeats. However, if the AC-ON signal is present, a check is made (s18) to determine whether the DC signal check is OK (see Fig. 2 ; i.e. a check that the DC signals - right hand side of the circuit - mean that the TV is in stand-by mode or that the TV is working properly). If it is, then normal operation is started (s20); otherwise, the system goes into stand-by mode (s22).

The steps s10 and s12 are used because, at this point, stand-by voltages exist and microcontroller 502 is working. But in order to be sure about the AC power supply status, the AC-ON signal (i.e. a HIGH signal from the final (fourth) processing circuitry 104, or a LOW signal from the third output, indicating mains power is still present) is checked.

## Claims

1. A mains-powered electrical system, comprising:
a power sensing unit (100) comprising,
• an antenna (102), adapted to be mounted on or near a mains cable of the electrical system, for providing, in use, an induced signal (105) when the mains cable is conveying electrical power and
• an analog signal processing circuit (104), coupled to the antenna (102), for receiving the induced signal (105) and outputting a power sense signal, indicative of whether or not the mains cable is conveying electrical power;
processing circuitry (502); a plurality of circuitry units (504-510); user interface (Ul) circuitry;
**characterized in that** the processing circuitry (502) is coupled to the power sensing unit (100) and to the plurality of circuitry units (504-510), and wherein the processing circuitry (502)is programmed for receiving a first user input signal (POWER OFF) from the user interface circuitry; and
transmitting a first control signal to one or more of said plurality of circuitry units (504-510) if the power sense signal (114, 118) indicates that the mains cable is not conveying electrical power, thereby disabling one or each of the plurality of said circuitry units (504-510).

2. The electrical system according to claim 1, wherein said plurality of circuitry units (504-510)include:
an intermediate control unit (506), coupled to the processing circuitry (502), and an audio amplifier (508), coupled to the intermediate control unit (506).

3. The electrical system according to claim 2, wherein the intermediate control unit (506) is operable, in response to the first control signal from the processing circuitry (502), for transmitting a second control signal to the audio amplifier (508), thereby disabling the audio amplifier (508).

4. An A/V system, comprising:
the system according to any of claims 2 to 3 wherein the audio amplifier (508) comprises an audio amplification circuit; and wherein the intermediate control unit (506) comprises an audio amp mute circuit.

5. The system according to claim 4, embodied in a TV system, computer, VCR, DVD player, or set-top box.

6. A method carried out in a mains-powered electrical system, comprising:
providing an antenna (102), adapted to be mounted on or near a mains cable of the electrical system; and
generating an induced signal using the antenna (102);
using an analog signal processing circuit (102), receiving the induced signal (105) and outputting a power sense signal (114, 118), of whether or not the mains cable is conveying electrical power;
**characterised in that** the electrical system comprises: a power sensing unit (100), associated with mains supply of the electrical system and incorporating the analog signal processing circuit (102), for providing, in use, said power sense signal indicative of whether or not the mains cable is conveying electrical power; processing circuitry (502); a plurality of circuitry units (504-510); and user interface (Ul) circuitry; wherein the processing circuitry (502) is coupled to the power sensing unit (100) and to the plurality of circuitry units (504-510); and **in that** method comprises:
receiving (s2) a first user input signal (POWER OFF) from the user interface (UI) circuitry; and transmitting (s8) a first control signal to one or more of said plurality of circuitry units (504-510) if the power sense signal (114, 118) indicates that the mains cable is not conveying electrical power, thereby disabling the or each of said circuitry units (504-510).

7. The method according to claim 6, wherein said circuitry units (504-510) include:
an intermediate control unit (506), coupled to the processing circuitry (502), and an audio amplifier (508), coupled to the intermediate control unit (506); and the method comprises
operating the intermediate control unit (506), in response to the first control signal from the processing circuitry (502), to transmit a second control signal to the audio amplifier (508), thereby disabling the audio amplifier (508).

8. The method according to claim 7 carried out in an A/V system,
wherein the audio amplifier (508) comprises an audio amplification circuit;
and wherein the intermediate control unit (506) comprises an audio amp mute circuit.

9. A programmable electrical system when suitably programmed for carrying out at least the steps of the methods according to any of claims 6 to 8.

10. A recordable, rewritable or storable medium having recorded or stored thereon data defining or transformable into instructions for execution by processing circuitry and corresponding to at least the steps of the method according to any of claims 6 to 8.

11. A server computer incorporating a communications device and a memory device and being adapted for transmission on demand or otherwise of data defining or transformable into instructions for execution by processing circuitry and corresponding to at least the steps of the method according to any of claims 6 ot 8.

## Patentansprüche

1. Netzversorgtes elektrisches System mit
einer Leistungssensoreinheit (100) mit
• einer Antenne, die dazu ausgestaltet ist, um an oder nahe an einem Netzkabel des elektrischen Systems montiert zu werden, um im Betrieb ein induziertes Signal (105) zu liefern, wenn das Netzkabel elektrische Leistung überträgt, und
• einer analogen Signalverarbeitungsschaltung (104), die mit der Antenne (102) verbunden ist, um das induzierte Signal (105) zu empfangen und ein Leistungserfassungssignal auszugeben, das anzeigt, ob das Netzkabel elektrische Leistung überträgt oder nicht,
Verarbeitungsschaltungen (502), einer Mehrzahl von Schaltungseinheiten (504 - 510), einer Benutzerschnittstellenschaltung (UI),
**dadurch gekennzeichnet, dass** die Verarbeitungsschaltungen (502) mit der Leistungssensoreinheit (100) und mit der Mehrzahl von Schaltungseinheiten (504 - 510) verbunden sind, und wobei die Verarbeitungsschaltungen (502) dazu programmiert sind, um ein erstes Benutzereingabesignal (POWER OFF) von der Benutzerschnittstellenschaltung zu empfangen und um ein erstes Steuersignal zu einer oder mehreren der Mehrzahl von Schaltungseinheiten (504 - 510) zu senden, wenn das Leistungserfassungssignal (114, 118) anzeigt, dass das Netzkabel keine elektrische Leistung überträgt, wodurch eine oder jede der Mehrzahl von Schaltungseinheiten (504 - 510) deaktiviert wird.

2. Elektrisches System nach Anspruch 1, wobei die Mehrzahl von Schaltungseinheiten (504 - 510) umfasst:
eine Zwischensteuerungseinheit (506), die mit den Verarbeitungsschaltungen (502) verbunden ist, und
einen Audioverstärker (508), der mit der Zwischensteuerungseinheit (506) verbunden ist.

3. Elektrisches System nach Anspruch 2, wobei die Zwischensteuerungseinheit (506) dazu betreibbar ist, um, in Reaktion auf das erste Steuersignal von den Verarbeitungsschaltungen (502), ein zweites Steuersignal zu dem Audioverstärker (508) zu senden, wodurch der Audioverstärker (508) deaktiviert wird.

4. A/V-System mit:
dem System nach einem der Ansprüche 2 bis 3, wobei der Audioverstärker (508) eine Audioverstärkungsschaltung aufweist und wobei die Zwischensteuerungseinheit (506) einen Audioverstärker-Stummschaltungsschaltkreis aufweist.

5. System nach Anspruch 4, das in einem TV-System, einem Computer, einem Videorekorder, einem DVD-Abspielgerät oder einer Set-Top-Box realisiert ist.

6. Verfahren, das in einem netzversorgten elektrischen System ausgeführt wird, bei dem:
eine Antenne (102) bereitgestellt wird, die dazu ausgestaltet ist, um an oder nahe an einem Netzkabel des elektrischen Systems montiert zu werden, und
unter Verwendung der Antenne (102) ein induziertes Signal erzeugt wird,
eine analoge Signalverarbeitungsschaltung (102) verwendet wird, die das induzierte Signal (105) empfängt und ein Leistungserfassungssignal (114, 118) ausgibt, das anzeigt, ob das Netzkabel elektrische Leistung überträgt oder nicht,
**dadurch gekennzeichnet, dass** das elektrische System aufweist: eine Leistungssensoreinheit (100), die der Netzversorgung des elektrischen Systems zugeordnet ist und die die analoge Signalverarbeitungsschaltung (102) umfasst, um im Betrieb das Leistungserfassungssignal zu liefern, das anzeigt, ob das Netzkabel elektrische Leistung überträgt oder nicht, Verarbeitungsschaltungen (502), eine Mehrzahl von Schaltungseinheiten (504 - 510) und eine Benutzerschnittstellenschaltung (UI), wobei die Verarbeitungsschaltungen mit der Leistungssensoreinheit (100) und der Mehrzahl von Schaltungseinheiten (504 - 510) verbunden ist, und dass das Verfahren beinhaltet:
Empfangen (S2) eines ersten Benutzereingabesignals (POWER OFF) von der Benutzerschnittstellenschaltung und
Senden (S8) eines ersten Steuersignals zu einer oder mehreren der Mehrzahl von Schaltungseinheiten (504 - 510), wenn das Leistungserfassungssignal (114, 118) anzeigt, dass das Netzkabel keine elektrische Leistung überträgt, wodurch die oder jede der Schaltungseinheiten (504 - 510) deaktiviert wird.

7. Verfahren nach Anspruch 6, wobei die Schaltungseinheiten (504 - 510) aufweisen:
eine Zwischensteuerungseinheit (506), die mit den Verarbeitungsschaltungen (502) verbunden ist, und einen Audioverstärker (508), der mit der Zwischensteuerungseinheit (506) verbunden ist, und wobei das Verfahren beinhaltet, die Zwischensteuerungseinheit in Reaktion auf das erste Steuersignal von den Verarbeitungsschaltungen (502) dazu zu betreiben, ein zweites Steuersignal zu dem Audioverstärker (508) zu senden, wodurch der Audioverstärker (508) deaktiviert wird.

8. Verfahren nach Anspruch 7, das in einem A/V-System ausgeführt wird, wobei der Audioverstärker (508) eine Audioverstärkungsschaltung aufweist und wobei die Zwischensteuerungseinheit (506) einen Audioverstärker-Stummschaltungsschaltkreis aufweist.

9. Programmierbares elektrisches System, das bei geeigneter Programmierung zur Ausführung wenigstens der Schritte der Verfahren gemäß einem der Ansprüche 6 bis 8 vorbereitet ist.

10. Beschreibbares, wieder-beschreibbares oder speicherungsfähiges Medium, das aufgezeichnet oder gespeichert darauf Daten aufweist, die Instruktionen definieren oder in Instruktionen transformierbar sind, die zur Ausführung durch Verarbeitungsschaltungen und entsprechend wenigstens den Schritten des Verfahrens gemäß einem der Ansprüche 6 bis 8 geeignet sind.

11. Server-Computer, der eine Kommunikationsvorrichtung und eine Speichereinheit enthält und dazu eingerichtet ist, auf Anforderung oder auf andere Weise Daten zu übertragen, die Instruktionen definieren oder in Instruktionen transformierbar sind, die zur Ausführung durch Verarbeitungsschaltungen und entsprechend wenigstens den Schritten des Verfahrens nach einem der Ansprüche 6 bis 8 geeignet sind.

## Revendications

1. Système électrique alimenté par secteur, comprenant :
une unité de détection de puissance (100) comprenant,
• une antenne (102), adaptée pour être montée sur ou à proximité d'un câble secteur du système électrique, pour fournir, en utilisation, un signal induit (105) lorsque le câble secteur transporte de la puissance électrique et
• un circuit de traitement de signal analogique (104), couplé à l'antenne (102), pour recevoir le signal induit (105) et délivrer en sortie un signal de détection de puissance, indiquant si le câble secteur transporte ou non de la puissance électrique ;
des circuits de traitement (502) ; une pluralité d'unités de circuits (504-510) ; des circuits d'interface utilisateur (UI) ;
**caractérisé en ce que**
les circuits de traitement (502) sont couplés à l'unité de détection de puissance (100) et à la pluralité d'unités de circuits (504-510), et dans lequel les circuits de traitement (502) sont programmés pour
recevoir un premier signal d'entrée d'utilisateur (POWER OFF) à partir des circuits d'interface utilisateur ; et
transmettre un premier signal de commande à une ou plusieurs de ladite pluralité d'unités de circuits (504-510) si le signal de détection de puissance (114, 118) indique que le câble secteur ne transporte pas de puissance électrique, en désactivant ainsi une ou chacune de la pluralité desdites unités de circuits (504-510).

2. Système électrique selon la revendication 1, dans lequel ladite pluralité d'unités de circuits (504-510) inclut :
une unité de commande intermédiaire (506), couplée aux circuits de traitement (502), et
un amplificateur audio (508), couplé à l'unité de commande intermédiaire (506).

3. Système électrique selon la revendication 2, dans lequel l'unité de commande intermédiaire (506) est opérationnelle, en réponse au premier signal de commande provenant des circuits de traitement (502), pour transmettre un second signal de commande à l'amplificateur audio (508), en désactivant ainsi l'amplificateur audio (508).

4. Système A/V, comprenant :
le système selon l'une quelconque des revendications 2 à 3 dans lequel l'amplificateur audio (508) comprend un circuit d'amplification audio ;
et dans lequel l'unité de commande intermédiaire (506) comprend un circuit de coupure d'amplification audio.

5. Système selon la revendication 4, incorporé dans un système de télévision, ordinateur, magnétoscope, lecteur DVD, ou décodeur.

6. Procédé mis en œuvre dans un système électrique alimenté par secteur, comprenant les étapes consistant à :
fournir une antenne (102), adaptée pour être montée sur ou à proximité d'un câble secteur du système électrique ; et
générer un signal induit en utilisant l'antenne (102) ;
utiliser un circuit de traitement de signal analogique (102), recevoir le signal induit (105) et délivrer en sortie un signal de détection de puissance (114, 118), indiquant si le câble secteur transporte ou non de la puissance électrique ;
**caractérisé en ce que** le système électrique comprend : une unité de détection de puissance (100), associée à l'alimentation secteur du système électrique et incorporant le circuit de traitement de signal analogique (102), pour fournir, en utilisation, ledit signal de détection de puissance indiquant si le câble secteur transporte ou non de la puissance électrique ; des circuits de traitement (502) ; une pluralité d'unités de circuits (504-510) ; et des circuits d'interface utilisateur (UI) ; dans lequel les circuits de traitement (502) sont couplés à l'unité de détection de puissance (100) et à la pluralité d'unités de circuits (504-510) ; et **en ce que** le procédé comprend les étapes consistant à :
recevoir (s2) un premier signal d'entrée d'utilisateur (POWER OFF) à partir des circuits d'interface utilisateur (UI) ; et
transmettre (s8) un premier signal de commande à une ou plusieurs de ladite pluralité d'unités de circuits (504-510) si le signal de détection de puissance (114, 118) indique que le câble secteur ne transporte pas de puissance électrique, en désactivant ainsi la ou chacune desdites unités de circuits (504-510).

7. Procédé selon la revendication 6, dans lequel lesdites unités de circuit (504-510) incluent :
une unité de commande intermédiaire (506), couplée aux circuits de traitement (502), et un amplificateur audio (508), couplé à l'unité de commande intermédiaire (506) ; et le procédé comprend l'étape consistant à
actionner l'unité de commande intermédiaire (506), en réponse au premier signal de commande provenant des circuits de traitement (502), pour transmettre un second signal de commande à l'amplificateur audio (508), en désactivant ainsi l'amplificateur audio (508).

8. Procédé selon la revendication 7 exécuté dans un système A/V,
dans lequel l'amplificateur audio (508) comprend un circuit d'amplification audio ;
et dans lequel l'unité de commande intermédiaire (506) comprend un circuit de coupure d'amplification audio.

9. Système électrique programmable, lorsqu'il est convenablement programmé, pour effectuer au moins les étapes des procédés selon l'une quelconque des revendications 6 à 8.

10. Support enregistrable, réinscriptible ou stockable présentant des données enregistrées ou stockées sur celui-ci, définissant ou transformables en instructions pour exécution par des circuits de traitement et correspondant au moins aux étapes du procédé selon l'une quelconque des revendications 6 à 8.

11. Ordinateur serveur incorporant un dispositif de communication et un dispositif de mémoire et étant adapté pour une transmission à la demande ou non de données définissant ou transformables en instructions pour exécution par des circuits de traitement et correspondant au moins aux étapes du procédé selon l'une quelconque des revendications 6 à 8.
